# EUROPÄISCHE PATENTSCHRIFT

(11) **EP 2 163 459 B1**
(45) Veröffentlichungstag und Bekanntmachung des Hinweises auf die Patenterteilung: **31.10.2018**
(21) Anmeldenummer: 09009757.7
(22) Anmeldetag: 28.07.2009
(51) Int. Cl.: B62D 25/06, B62D 29/04, H01L 31/048, B29C 70/48, B29C 70/72

(54) **Verfahren zur Herstellung eines Bauteils, insbesondere eines Aussenhautteils für Fahrzeuge**
Method for producing a component, in particular of an outer body panel for motor vehicles
Procédé de fabrication d'un composant, notamment d'une partie de peau extérieure pour véhicules

(30) Priorität: 11.09.2008 DE 102008046765
(43) Veröffentlichungstag der Anmeldung: 17.03.2010
(73) Patentinhaber: Bayerische Motoren Werke Aktiengesellschaft, 80809 München (DE)
(72) Erfinder: Mohr, Philipp, 84030 Ergolding (DE)

(56) Entgegenhaltungen:
- WO-A1-96/02947
- WO-A1-2010/017847
- DE-A1-102004 003 856
- DE-A1-102005 050 372
- FR-A1- 2 934 418
- US-A- 5 008 062
- US-A1- 2005 152 139

## Beschreibung

Die vorliegende Erfindung betrifft ein Verfahren zur Herstellung eines Außenhautteils für Fahrzeuge, mit integrierter Solarzellenanordnung, gemäß den Merkmalen des Patentanspruches 1.

Zum relevanten Stand der Technik zählen die US 2005/152139 A1, DE 10 2004 003856 A1, DE 10 2005 050 372 A1, FR 2 934 418 A1, US 5,008,062 A sowie die WO 96/02947 A1.

Solarzellenanordnungen in Fahrzeugaußenhautteile zu integrieren ist seit langem bekannt und beschrieben, z.B. in der DE 203 09 281 U1, DE 10 2004 003 856 A1, DE 10 2007 021 989 A1, DE 10 2005 050 372 A1, DE 10 2004 003 328 B4, DE 103 13 000 A1, DE 102 18 198 C1, DE 103 05 938 A1, DE 102 59 472 B4, DE 102 47 856 A1, DE 196 30 813 A1, DE 43 28 291 A1, DE 203 20 910 U1, EP 0 221 287 B1 sowie WO 03/069682 A2.

Ein Glasschiebedach mit integrierter Solarzellenanordnung wurde bereits in der 3er-Baureihe von BMW angeboten. Das Glasschiebedach bestand aus einer Glasscheibe, auf die jeweils eine untere Schmelzklebefolie aufgebracht war. Zwischen die untere und eine obere Schmelzklebefolie wurde eine Solarzellenanordnung eingebracht und das gesamte "Schichtenpaket" erhitzt und zusammengepresst. Durch das Erhitzen wurden die Schmelzklebefolien aufgeschmolzen, was zu einem dauerhaften Verkleben der Schichten führte. Zum Schutz der oberen Schmelzklebefolie wurde auf die obere Schmelzklebefolie eine zusätzliche Schutzfolie aufgebracht. Bei derartigen Glasdächern war die Solarzellenanordnung zwar optimal geschützt. Der bei der Herstellung zum Einsatz kommende "Laminierungsprozess" war aber relativ zeit- und kostenaufwändig und mit einem hohen Anteil an Handarbeit verbunden.

Aufgabe der Erfindung ist es, ein Verfahren zur Herstellung eines Fahrzeugaußenhautteils mit integrierter Solarzellenanordnung anzugeben, das vergleichsweise zeit- und kosteneffizient ist, und das insbesondere zur Herstellung von Bauteilen mit geringem Gewicht geeignet ist.

Diese Aufgabe wird durch die Merkmale des Patentanspruches 1 gelöst. Vorteilhafte Ausgestaltungen und Weiterbildungen der Erfindung sind den Unteransprüchen zu entnehmen.

Gemäß der Erfindung wird zunächst ein Gewebe, wie z.B. ein Kohlefaser- oder Glasfasergewebe bzw. ein Gewebeverbund bereitgestellt, auf das bzw. auf den eine Solarzellenanordnung appliziert wird. Die Solarzellenanordnung und das Gewebe werden mittels eines Werkzeugs, das ein Werkzeugoberteil und ein Werkzeugunterteil aufweisen kann, aneinander gedrückt. Anschließend wird mittels einer Misch- und Dosieranlage ein flüssiges "Matrixmaterial" wie z.B. ein Harz-/Härter-Gemisch in das Werkzeug injiziert. Das Matrixmaterial wird in der folgenden Beschreibung und in den Patentansprüchen als "Harz" bezeichnet. Die Injektion des Harzes kann unterstützt werden, indem im Werkzeug ein Unterdruck bzw. ein Vakuum erzeugt wird. Das injizierte Harz durchdringt das Gewebe und verklebt die Solarzellenanordnung mit dem Gewebe zu einem "Rohteil". Je nach Reaktionstemperatur des Harzes kann vorgesehen sein, dass die Solarzellenanordnung und das Gewebe durch eine Heizeinrichtung während der Injektion des Harzes auf einer erhöhten Temperatur von z.B. 120°C gehalten werden. Hierzu kann das Werkzeug auf z.B. 130° temperiert werden. Anschließend wird das Harz ausgehärtet. Nach dem Aushärten des Harzes wird das Rohteil aus dem Werkzeug entnommen. Auf derjenigen Seite des Gewebes, auf der die Solarzellenanordnung angeordnet ist, wird eine Schutzschicht aufgebracht. Bei der Schutzschicht kann es sich z.B. um eine Lackschicht, eine Folie oder um eine Kunstharzschicht handeln. Durch Aufbringen der Schutzschicht wird nicht nur die Solarzellenanordnung vor Beschädigungen geschützt. Durch die Schutzschicht kann eine glatte, fugenlose Bauteiloberfläche dargestellt werden. Schließlich werden Ränder des Rohteils nachbearbeitet, z.B. durch Fräsen, Schleifen, etc.

Das oben beschriebene Verfahren ist insbesondere zur Herstellung sehr leichter Außenhautkomponenten von Fahrzeugen, wie z.B. leichten, aus Karbon- oder Glasfasern hergestellten Fahrzeugdächern geeignet. Prinzipiell eignet sich das erfindungsgemäße Verfahren aber auch zur Herstellung anderer Außenhautteile von Fahrzeugen, wie z.B. von Oberfächenteilen von Türen, Klappen, Seitenwänden etc.

Bei dem Gewebe kann es sich um ein elektrisch nicht leitendes oder um ein elektrisch leitendes Gewebe handeln. Als elektrisch nicht leitendes Gewebe eignen sich insbesondere Glasfasergewebe. Als elektrisch leitende Gewebe kommen z.B. Kohlefasergewebe in Betracht. Wird ein elektrisch leitendes Gewebe verwendet, so ist zwischen das Gewebe und die Solarzellenanordnung eine elektrisch isolierende Schicht einzubringen.

Nach einer Weiterbildung der Erfindung weist die Solarzellenanordnung elektrische Anschlüsse auf, die mit Leitern verbunden sind, welche unter der Schutzschicht verlaufend zu einer "Seite" des Bauteils aus dem Bauteil herausgeführt sind. Als Leiter kommen insbesondere Band- bzw. streifenartige Leiter, z.B. aus Kupfermaterial oder einem anderen elektrisch gut leitenden Material in Betracht.

Die Leiter können durch Aufdampfen eines entsprechend gut leitenden Materials auf das Gewebematerial hergestellt werden.

Die elektrischen Leiter müssen aber nicht notwendigerweise unter der Schutzschicht verlaufend aus dem Bauteil herausgeführt sein. Die elektrischen Leiter können auf durch ein "Loch" bzw. eine Öffnung aus dem Bauteil zu einer "Rückseite", d.h. zu einer der Außenhautseite abgewandten Seite des Bauteils herausgeführt sein, wobei das Loch bzw. die Öffnung durch das Harz abgedichtet wird.

## Patentansprüche

1. Verfahren zur Herstellung eines Außenhautteils für Fahrzeuge, mit integrierter Solarzellenanordnung, mit folgenden Schritten:
- Bereitstellen eines Gewebes oder eines Gewebeverbunds,
- Anordnen einer Solarzellenanordnung auf dem Gewebe,
- Andrücken der Solarzellenanordnung an das Gewebe mittels eines Werkzeugs,
- Injizieren flüssigen Harzes in das Werkzeug, derart, dass die Solarzellenanordnung mit dem Gewebe zu einem Rohteil verklebt,
- Aushärten des Harzes,
- Entnehmen des Rohteils aus dem Werkzeug,
- Überziehen des Rohteils mit einer Schutzschicht, so dass sich eine glatte, fugenlose Rohteiloberfläche ergibt,
- Nachbearbeiten der Ränder des Rohteils, wodurch man das Bauteil erhält.

2. Verfahren nach Anspruch 1,
**dadurch gekennzeichnet, dass** es sich bei dem Gewebe um ein Glasfasergewebe handelt.

3. Verfahren nach einem der Ansprüche 1,
**dadurch gekennzeichnet, dass** es sich bei dem Gewebe um ein elektrisch leitfähiges Gewebe handelt, wobei zwischen das Gewebe und die Solarzellenanordnung eine elektrisch isolierende Schicht eingebracht wird.

4. Verfahren nach Ansprüche 3,
**dadurch gekennzeichnet, dass** es sich bei dem Gewebe um ein Gewebe handelt, das ganz oder teilweise aus Kohlefasern hergestellt ist.

5. Verfahren nach einem der Ansprüche 1 bis 4,
**dadurch gekennzeichnet, dass** die Solarzellenanordnung elektrische Anschlüsse aufweist, die mit Leitern verbunden sind, welche unter der Schutzschicht verlaufend aus dem Bauteil heraus zu einer Seite des Bauteils geführt sind.

6. Verfahren nach Anspruch 5,
**dadurch gekennzeichnet, dass** die Leiter die Form flacher Bänder bzw. Streifen haben.

7. Verfahren nach Anspruch 5 oder 6,
**dadurch gekennzeichnet, dass** die Leiter aus einem kupferhaltigen Material hergestellt sind.

8. Verfahren nach einem der Ansprüche 5 bis 7,
**dadurch gekennzeichnet, dass** die Leiter durch Aufdampfen auf das Gewebe hergestellt werden.

9. Verfahren nach einem der Ansprüche 1 bis 8,
**dadurch gekennzeichnet, dass** es sich bei der Schutzschicht um eine Lackschicht oder um eine Folie handelt.

10. Verfahren nach einem der Ansprüche 1 bis 9,
**dadurch gekennzeichnet, dass** es sich bei dem Bauteil um das Dach eines Fahrzeugs handelt.

## Claims

1. A method for producing an outer skin part for vehicles, with an integrated solar cell arrangement, having the following steps:
- providing a fabric or a fabric composite,
- arranging a solar cell arrangement on the fabric,
- pressing the solar cell arrangement onto the fabric by means of a mould,
- injecting liquid resin into the mould, such that the solar cell arrangement glues to the fabric to form a raw part,
- curing the resin,
- removing the raw part from the mould,
- covering the raw part with a protective layer, so that a smooth, joint-less raw-part surface is yielded,
- subsequently processing the edges of the raw part, as a result of which the component is obtained.

2. A method according to Claim 1,
**characterised in that** the fabric is a glass fibre fabric.

3. A method according to Claim 1,
**characterised in that** the fabric is an electrically conductive fabric, with an electrically insulating layer being introduced between the fabric and the solar cell arrangement.

4. A method according to Claim 3,
**characterised in that** the fabric is a fabric which is produced entirely or partly from carbon fibres.

5. A method according to one of Claims 1 to 4,
**characterised in that** the solar cell arrangement has electrical connectors which are connected to conductors which are guided, running beneath the protective layer, out of the component on one side of the component.

6. A method according to Claim 5,
**characterised in that** the conductors are in the form of flat bands or strips.

7. A method according to Claim 5 or Claim 6,
**characterised in that** the conductors are produced from a copper-containing material.

8. A method according to one of Claims 5 to 7,
**characterised in that** the conductors are produced by vapour deposition onto the fabric.

9. A method according to one of Claims 1 to 8,
**characterised in that** the protective layer is a paint layer or a film.

10. A method according to one of Claims 1 to 9,
**characterised in that** the component is the roof of a vehicle.

## Revendications

1. Procédé de fabrication d'un composant de peau extérieure de véhicule avec un dispositif de cellules solaires intégrées comprenant les étapes suivantes consistant à :
- fournir un tissu ou une combinaison de tissus,
- installer un dispositif de cellules solaires sur le tissu,
- presser le dispositif de cellules solaires contre le tissu à l'aide d'un outil,
- injecter de la résine liquide dans l'outil de façon à faire coller le dispositif de cellules solaires avec le tissu et obtenir une pièce brute,
- laisser durcir la résine,
- extraire la pièce brute de l'outil,
- revêtir la pièce brute avec une couche protectrice pour obtenir une surface lisse, sans intervalle, de la pièce brute,
- faire la finition des bords de la pièce brute pour obtenir le composant.

2. Procédé selon la revendication 1,
**caractérisé en ce que**
le tissu est un tissu de fibres de verre.

3. Procédé selon la revendication 1,
**caractérisé en ce que**
le tissu est un tissu électroconducteur et on intercale une couche d'isolation électrique entre le tissu et le dispositif de cellules solaires.

4. Procédé selon la revendication 3,
**caractérisé en ce que**
le tissu de base est un tissu réalisé en totalité ou en partie avec des fibres de carbone.

5. Procédé selon l'une des revendications 1 à 4,
**caractérisé en ce que**
le dispositif de cellules solaires comporte des branchements électriques reliés à des conducteurs qui passent sous la couche protectrice et sortent de la pièce d'un côté de celle-ci.

6. Procédé selon la revendication 5,
**caractérisé en ce que**
les conducteurs sont sous la forme de rubans plats ou de bandes.

7. Procédé selon la revendication 5 ou 6,
**caractérisé en ce que**
les conducteurs sont réalisés en un matériau contenant du cuivre.

8. Procédé selon l'une des revendications 5 à 7,
**caractérisé en ce que**
les conducteurs sont obtenus par un dépôt à la vapeur sur le tissu.

9. Procédé selon l'une des revendications 1 à 8,
**caractérisé en ce que**
la couche protectrice est une couche de verni ou un film.

10. Procédé selon l'une des revendications 1 à 9,
**caractérisé en ce que**
le composant est le toit d'un véhicule.
